# EUROPEAN PATENT SPECIFICATION

(11) **EP 4 257 992 B1**
(45) Date of publication and mention of the grant of the patent: **25.11.2026**
(21) Application number: 21905200.8
(22) Date of filing: 27.09.2021
(51) Int. Cl.: H02J 3/38, G01R 31/00, G01R 31/08, G01R 31/34, H02J 3/12

(54) **WIND GENERATOR SET, CONVERTER, AND LOW-VOLTAGE RIDE-THROUGH DETECTION METHOD AND DEVICE**
WINDGENERATORSATZ, WANDLER UND VERFAHREN UND VORRICHTUNG ZUR ERKENNUNG EINES NIEDRIGSPANNUNGSDURCHLAUFS
ENSEMBLE GÉNÉRATEUR ÉOLIEN, CONVERTISSEUR ET PROCÉDÉ ET DISPOSITIF DE DÉTECTION DE TENUE AUX CREUX DE TENSION

(30) Priority: 15.12.2020 CN 202011479355
(43) Date of publication of application: 11.10.2023
(73) Proprietor: Goldwind Science & Technology Co., Ltd., Urumqi, Xinjiang 830026 (CN)
(72) Inventor: WU, Lei, Beijing 100176 (CN)
(74) Representative: Gulde & Partner
(86) International application number: PCT/CN2021/120987
(87) International publication number: WO 2022/127270

(56) References cited:
- EP-B1- 2 859 638
- CN-A- 101 968 032
- CN-A- 102 121 966
- CN-A- 104 795 842
- CN-A- 105 281 366
- CN-A- 106 953 355
- CN-A- 110 581 565
- CN-A- 111 327 075
- CN-A- 113 325 246
- CN-B- 106 953 355
- US-A1- 2012 150 524
- OUYANG SEN;MA WENJIE: "Low voltage ride through control strategy of photovoltaic inverter considering voltage fault type", ELECTRIC POWER AUTOMATION EQUIPMENT, vol. 38, no. 9, 3 September 2018 (2018-09-03), pages 21 - 26, XP055944362, ISSN: 1006-6047, DOI: 10.16081/j.issn.1006-6047.2018.09.004
- WANG, GUO-QUAN; CHANG, HAI-SONG; HAN, JIAN-PENG: "Study on Optimization of Low Voltage Ride through for Doubly Fed Wind Power Generation System", TELECOM POWER TECHNOLOGY, vol. 34, no. 1, 25 January 2017 (2017-01-25), CN , pages 126 - 127, XP009537672, ISSN: 1009-3664, DOI: 10.19399/j.cnki.tpt.2017.01.050
- CHEN WEIZU , SUN LIGUO , DAI DEGANG: "A review of research on low-voltage ride-through technology in photovoltaic grid-connected", TECHNOLOGY WIND, 25 December 2013 (2013-12-25), pages 43 - 43, XP055944363, ISSN: 1671-7341, DOI: 10.19392/j.cnki.1671-7341.2013.24.035
- CHEN TIANYI;CHEN LAIJUN;ZHENG TIANWEN;MEI SHENGWE: "LVRT Control Method of Virtual Synchronous Generator Based on Mode Smooth Switching", POWER SYSTEM TECHNOLOGY, vol. 40, no. 7, 6 May 2016 (2016-05-06), pages 2134 - 2140, XP055944365, ISSN: 1000-3673, DOI: 10.13335/j.1000-3673.pst.2016.07.030

## Description

### TECHNICAL FIELD

The present disclosure relates to the field of wind power generation technologies. More particularly, the present disclosure relates to a wind turbine, a converter, and a low-voltage ride-through detection method and device.

### BACKGROUND

When a wind turbine is connected to a weak grid, a voltage drop formed by a grid-connected current of the wind turbine and a line impedance function has a significant effect on an end voltage of the wind turbine. When a far end of the power grid fails, there is a phenomenon that the end voltage of the wind turbine does not drop and the system oscillates.

US 2012150524 A1 discloses a fault-ride-through method including detecting a voltage dip on a power line transmitting electric power. If a voltage dip is detected, the method includes reducing an active current and/or an active power to a specific value, which active current and/or active power is fed by a power generating unit at a feeding point into a power network having a plurality of power lines.

EP 2859638 B1 discloses a wind power plant connected to an electric grid. A central plant controller is configured to carry out a method of controlling an electric output of the wind power plant in the event of a transient low-voltage fault of the electric grid. The central plant controller is configured, after a fault stage in response to detection of a low-voltage fault during which the wind turbines ride through the grid fault, to control the wind power plant during a post-fault-support stage to provide only real power, or perform voltage control. The central plant controller is configured to resume control of the wind power plant according to the nominal-grid operation mode, which prevailed before the low-voltage fault, in a nominal-grid operation stage.

CN 106953355 B discloses to a low-voltage ride-through control method and apparatus. A total current instruction value is generated by summation of a current instruction value which is obtained by difference between a high-voltage side voltage reference value and a high-voltage side actual positive sequence voltage of a power grid, and a current instruction value which is obtained by difference between an SVG side voltage reference value and an SVG side actual positive sequence voltage; then a difference value between the total current instruction value and the actual positive sequence current is obtained; and PWM modulation wave is generated through a regulator.

### SUMMARY

An exemplary embodiment of the present disclosure is to provide a wind turbine, a converter, and a low-voltage ride-through detection method and device to solve the problem of system instability in the process of a power grid fault ride-through in the weak grid.

According to an exemplary embodiment of the present disclosure, a low-voltage ride-through detection method is provided as defined by the appended set of claims.

According to an exemplary embodiment of the present disclosure, a low-voltage ride-through detection device is provided as defined by the appended set of claims.

According to an exemplary embodiment of the present disclosure, there is provided a converter, including the low-voltage ride-through detection device according to the exemplary embodiment of the present disclosure.

According to an exemplary embodiment of the present disclosure, there is provided a wind power generator set, including the converter according to the exemplary embodiment of the present disclosure.

According to an exemplary embodiment of the present disclosure, there is provided a computer-readable storage medium having stored thereon computer programs that, when executed by a processor, implement the low-voltage ride-through detection method according to the exemplary embodiment of the present disclosure.

According to an exemplary embodiment of the present disclosure, there is provided a computing device, including: at least one processor; at least one memory storing computer programs that, when executed by the at least one processor, implement the low-voltage ride-through detection method according to the exemplary embodiment of the present disclosure.

According to an exemplary embodiment of the present disclosure, there is provided a computer program product, wherein instructions in the computer program product are executable by a processor of a computer device to achieve the low-voltage ride-through detection method according to the exemplary embodiment of the present disclosure.

For the low-voltage ride-through detection method and device according to the exemplary embodiments of the present disclosure, by firstly determining an adjustment value of a preset parameter of a power grid on the basis of a power grid voltage, wherein the preset parameter includes at least one of a current, a current frequency and a power factor angle, adjusting the preset parameter of the power grid on the basis of the adjustment value, and then detecting, on the basis of a power grid voltage after the preset parameter of the power grid is adjusted, whether the power grid meets a low-voltage ride-through condition, a power grid fault can be accurately identified by the wind turbine in a weak grid, so as to enter a low-voltage ride-through state, thereby avoiding system instability in the process of a power grid fault ride-through in the weak grid.

Further aspects and/or advantages of the disclosed general concept will be set forth in part in the following description and, in part, will be obvious from the description, or may be learned by practice of the disclosed general concept.

### BRIEF DESCRIPTION OF THE DRAWINGS

The above and other purposes and features of exemplary embodiments of the present disclosure will become more apparent by the following detailed description in conjunction with the accompanying drawings showing embodiments by way of example, wherein:
Fig. 1 shows a flow diagram of a low-voltage ride-through detection method according to an exemplary embodiment of the present disclosure;
Fig. 2 shows a schematic diagram of a low-voltage ride-through hysteresis principle;
Fig. 3 shows a block diagram of a low-voltage ride-through detection device according to an exemplary embodiment of the present disclosure; and
Fig. 4 shows a schematic diagram of a computing device according to an exemplary embodiment of the present disclosure.

### DETAILED DESCRIPTION

Reference will now be made in detail to the exemplary embodiments of the present disclosure, examples of the embodiments are illustrated in the accompanying drawings, wherein like reference numerals refer to the like components throughout. The embodiments will be described below by referring to the accompanying drawings in order to explain the present disclosure.

An end voltage *E̅_{WT}* of a wind turbine can be constrained by a node voltage *E̅_{g}* and a line impedance voltage drop *E̅_{z}* of a power grid. For example, *E̅_{WT}* = *E̅_{g}* + *E̅_{z}*. The line impedance voltage drop *E̅_{z}* is related to a line impedance Z, an output current amplitude *̅I̅*̅ of the wind turbine, a current frequency *f*, a power factor angle, etc. For example, *E̅_{z}* = 2 × *π* × *f* × *Z* × *̅I̅*̅. Thus, even if the node voltage of the power grid has dropped, the line impedance voltage drop may also cause an end voltage of the wind turbine not to fall below a low-voltage ride-through threshold, thereby causing the wind turbine not to operate in a low-voltage ride-through state.

The present disclosure proposes to use a scheme of injecting a disturbance into the power grid to reduce the impedance voltage drop, thereby realizing a low-voltage ride-through detection of the wind turbine.

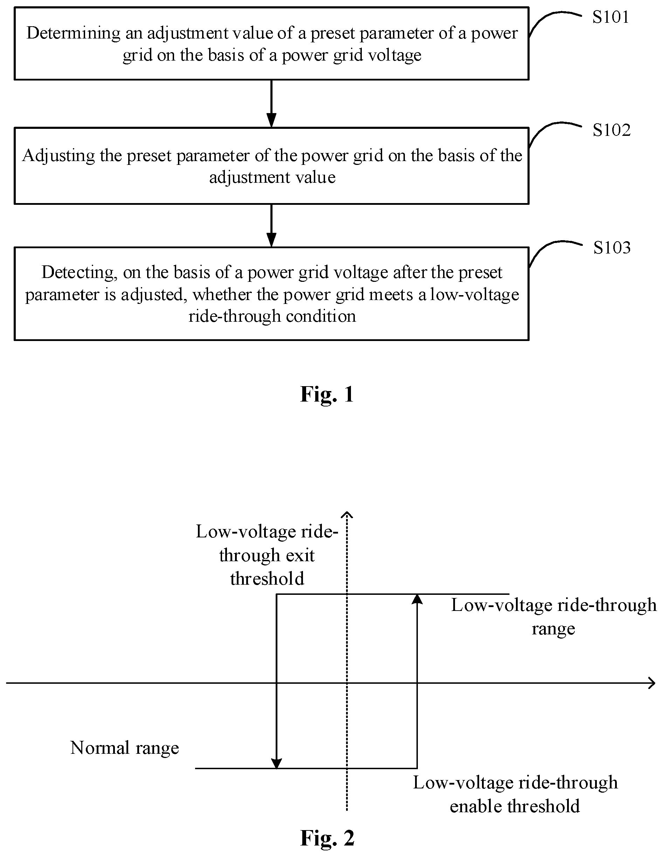

Fig. 1 shows a flow diagram of a low-voltage ride-through detection method according to an exemplary embodiment of the present disclosure.

Referring to Fig. 1, at step S101, an adjustment value of a preset parameter of a power grid is determined on the basis of a power grid voltage.

In an exemplary embodiment of the present disclosure, the preset parameter may include at least one of a current, a current frequency and a power factor angle. That is, if the preset parameter is at least one of a current, a current frequency and a power factor angle, an adjustment value of the at least one thereof may be determined on the basis of the power grid voltage, for example, if the preset parameter is a current, an adjustment value of the current of the power grid may be determined on the basis of the power grid voltage; if the preset parameter is a current frequency, an adjustment value of the current frequency of the power grid may be determined on the basis of the power grid voltage; if the preset parameter is a power factor angle, an adjustment value of the power factor angle of the power grid may be determined on the basis of the power grid voltage; if the preset parameters are a current and a power factor angle, an adjustment value of the current and an adjustment value of the power factor angle of the power grid may be determined on the basis of the power grid voltage; if the preset parameters are a current and a current frequency, an adjustment value of the current and an adjustment value of the current frequency of the power grid may be determined on the basis of the power grid voltage; if the preset parameters are a current, a current frequency and a power factor angle, an adjustment value of the current, an adjustment value of the current frequency and an adjustment value of the power factor angle of the power grid may be determined on the basis of the grid voltage.

In an exemplary embodiment of the present disclosure, when determining an adjustment value of a preset parameter of a power grid on the basis of a power grid voltage, a Q-axis component of the power grid voltage may be acquired firstly and then an active current limiting amplitude output by a wind turbine may be calculated on the basis of the Q-axis component of the power grid voltage.

In an exemplary embodiment of the present disclosure, when acquiring the Q-axis component of the power grid voltage, the Q-axis component of the power grid voltage may be calculated by a converter phase-locked loop of the power grid. In particular, the Q-axis component of the power grid voltage calculated by the converter phase-locked loop may be used as a trigger factor of a disturbing current.

In an exemplary embodiment of the present disclosure, when calculating the active current limiting amplitude output by the wind turbine on the basis of the Q-axis component of the power grid voltage, a filtering process may be performed on the Q-axis component of the power grid voltage firstly, and then the active current limiting amplitude output by the wind turbine may be calculated according to the processed Q-axis component, thereby improving stability of the power grid. Preferably, in order to perform low-voltage ride-through detection quickly, when performing a filtering process on the Q-axis component of the power grid voltage, a filter delay should not exceed 1/4 of a work frequency period.

In an exemplary embodiment of the present disclosure, when determining the adjustment value of the preset parameter of the power grid on the basis of the power grid voltage, the Q-axis component of the power grid voltage may firstly be calculated by the converter phase-locked loop, a filtering process may be performed on the Q-axis component of the power grid voltage, and then the active current limiting amplitude output by the wind turbine may be calculated according to the processed Q-axis component.

In an exemplary embodiment of the present disclosure, when calculating the active current limiting amplitude output by the wind turbine according to the processed Q-axis component, an apparent current output by the wind turbine may firstly be calculated on the basis of the processed Q-axis component and a rated grid-connected apparent current of a wind turbine, and then the active current limiting amplitude output by the wind turbine may be calculated on the basis of the apparent current output by the wind turbine. For example, the active current limiting amplitude output by the wind turbine may be calculated according to the formula ${I}_{d _ Max} = \sqrt{{I}_{s}^{2} - {I}_{q _ ref}^{2}}$. Herein, Is is the apparent current at an inverter side of a converter, E_{q} is the Q-axis component of the power grid voltage calculated by the converter phase-locked loop, I_{s_rated} is the rated grid-connected apparent current of the set, I_{q_ref} is a reactive current reference value of the set, I_{d_max} is the active current limiting amplitude, and K is an intensity adjustment gain.

In an exemplary embodiment of the present disclosure, a filtering process may also be performed on the calculated active current limiting amplitude I_{d_max}. Variable rate filtering may be performed when performing a filtering process on the calculated active current limiting amplitude I_{d_max}. For example, the variable rate filtering may be applied to the calculated active limiting amplitude I_{d_max}. No filtering is performed when I_{d_max} decreases and low-pass filtering is performed when I_{d_max} increases.

At step S102, the preset parameter of the power grid is adjusted on the basis of the determined adjustment value.

In particular, if the preset parameter is at least one of a current, a current frequency and a power factor angle, the at least one thereof may be adjusted on the basis of the determined adjustment value of the at least one thereof, for example, if the preset parameter is a current, a current of the power grid may be adjusted on the basis of the determined adjustment value of the current; if the preset parameter is a current frequency, a current frequency of the power grid may be adjusted on the basis of the determined adjustment value of the current frequency; if the preset parameter is a power factor angle, an power factor angle of the power grid may be adjusted on the basis of the determined adjustment value of the power factor angle; if the preset parameters are a current and a power factor angle, a current and an power factor angle of the power grid may be adjusted on the basis of the determined adjustment value of the current and the determined adjustment value of the power factor angle, respectively; if the preset parameters are a current and a current frequency, a current and a current frequency of the power grid may be adjusted on the basis of the determined adjustment value of the current and the determined adjustment value of the current frequency, respectively; if the preset parameters are a current, a current frequency and a power factor angle, a current, a current frequency and a power factor angle of the power grid may be adjusted on the basis of the determined adjustment value of the current, the determined adjustment value of the current frequency and the determined adjustment value of the power factor angle, respectively.

At step S103, it is detected that, on the basis of a power grid voltage after the preset parameter of the power grid is adjusted, whether the power grid meets a low-voltage ride-through condition.

In an exemplary embodiment of the present disclosure, when detecting, on the basis of a power grid voltage after the preset parameter of the power grid is adjusted, whether the power grid meets a low-voltage ride-through condition, a D-axis component and a Q-axis component of the power grid voltage after the preset parameter of the power grid is adjusted may firstly be acquired, a vector sum of the D-axis component and the Q-axis component of the power grid voltage after the preset parameter is adjusted may be calculated to obtain a positive sequence voltage amplitude of the power grid voltage after the preset parameter is adjusted, and a low-pass filtering process may be performed on the positive sequence voltage amplitude, and then it may be detected that, on the basis of the processed positive sequence voltage amplitude and a preset low-voltage ride-through threshold, whether the power grid meets a low-voltage ride-through condition. For example, a positive sequence component of a three-phase voltage may firstly be extracted using a symmetrical component method, and then Clark and Park transformations are performed on the positive sequence component of the three-phase voltage to obtain the D-axis component and the Q-axis component of the power grid voltage.

In an exemplary embodiment of the present disclosure, when detecting, on the basis of the processed positive sequence voltage amplitude and a preset low-voltage ride-through threshold, whether the power grid meets a low-voltage ride-through condition, a difference between the preset low-voltage ride-through threshold and the processed positive sequence voltage amplitude may firstly be calculated, the difference between the preset low-voltage ride-through threshold and the processed positive sequence voltage amplitude may be input to a hysteresis controller, and then under a condition that the difference between the preset low-voltage ride-through threshold and the processed positive sequence voltage amplitude is greater than an entering hysteresis value of the hysteresis controller, a delay counter starts to count, and it is determined that the power grid meets the low-voltage ride-through condition under a condition that the count value of the delay counter reaches a target delay; under a condition that the difference between the preset low-voltage ride-through threshold and the processed positive sequence voltage amplitude is less than an exit hysteresis value of the hysteresis controller, the delay counter starts to count, and it is determined that the power grid does not meet the low-voltage ride-through condition under a condition that the count value of the delay counter reaches the target delay.

Fig. 2 shows a schematic diagram of a low-voltage ride-through hysteresis principle. Hysteresis is to avoid boundary oscillations. Without hysteresis, assuming that the low-voltage ride-through threshold is 0.9pu, and then under a condition that the voltage is lower than 0.9pu, the converter will enter a low-voltage ride-through state, enters the low-voltage ride-through state and starts to supplement reactive power, the voltage rises, and under a condition that the voltage is higher than 0.9pu, the converter exits the low-voltage ride-through state. The reactive power is returned, the voltage drops below 0.9pu, the converter enters the low-voltage ride-through state again, and this process repeats to cause boundary oscillations.

With the hysteresis controller, as shown in Fig. 2, the low-voltage ride-through enable threshold for entering the low-voltage ride-through state is set to, for example, 0.87pu, and the low-voltage ride-through exit threshold for exiting the low-voltage ride-through state is set to, for example, 0.9pu, so that under a condition that the voltage is lower than 0.87pu, the converter enters the low-voltage ride-through state and starts to supplement the reactive power, and the converter will not exit the low-voltage ride-through state as long as the voltage does not rise above 0.9pu. Therefore, boundary oscillations are avoided. The 0.03pu between the 0.87pu and the 0.9pu is the range of the hysteresis, which is related to an impedance of the power grid and theoretically proportional to the impedance of the power grid.

Furthermore, according to an exemplary embodiment of the present disclosure, there is also provided a computer-readable storage medium having stored thereon computer programs that, when executed, implement the low-voltage ride-through detection method according to an exemplary embodiment of the present disclosure.

In an exemplary embodiment of the present disclosure, the computer-readable storage medium may carry one or more programs that, when executed, may implement the following steps: determining an adjustment value of a preset parameter of a power grid on the basis of a power grid voltage; adjusting the preset parameter of the power grid on the basis of the adjustment value; and detecting, on the basis of a power grid voltage after the preset parameter is adjusted, whether the power grid meets a low-voltage ride-through condition.

The computer-readable storage medium may be, for example but not limited to, an electronic, magnetic, optical, electromagnetic, infrared, or semiconductor system, device, or apparatus, or a combination of any of the above. More specific examples of the computer-readable storage medium may include, but are not limited to: an electrical connection having one or more wires, a portable computer magnetic disk, a hard disk, a random access memory (RAM), a read-only memory (ROM), an erasable programmable read-only memory (EPROM or Flash memory), an optical fiber, a portable compact disk read-only memory (CD-ROM), an optical storage device, a magnetic storage device, or any suitable combination of the above. In an embodiment of the present disclosure, a computer-readable storage medium may be any tangible medium that contains or stores computer programs that may be used by or in connection with an instruction execution system, device, or apparatus. Computer programs embodied on the computer-readable storage medium may be transmitted using any suitable medium including, but not limited to: wires, fiber optic cables, RF (Radio Frequency) and the like, or any suitable combination of the above. The computer readable storage medium may be embodied in any device; it may also be present separately and not fitted into the device.

Furthermore, according to an exemplary embodiment of the present disclosure, there is also provided a computer program product, wherein instructions in the computer program product are executable by a processor of a computer device to achieve the low-voltage ride-through detection method according to an exemplary embodiment of the present disclosure.

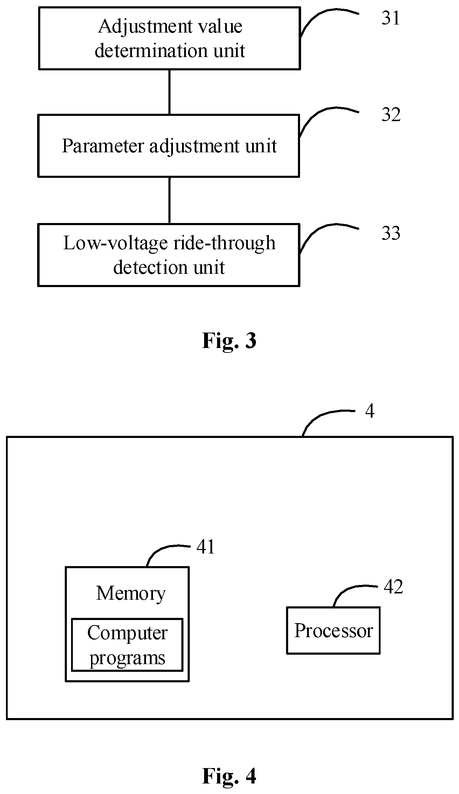

The low-voltage ride-through detection method according to an exemplary embodiment of the present disclosure has been described above in connection with Figs. 1 and 2. Hereinafter, a low-voltage ride-through detection device according to an exemplary embodiment of the present disclosure and its units will be described with reference to Fig. 3.

Fig. 3 shows a block diagram of the low-voltage ride-through detection device according to an exemplary embodiment of the present disclosure.

Referring to Fig. 3, the low-voltage ride-through detection device includes an adjustment value determination unit 31, a parameter adjustment unit 32, and a low-voltage ride-through detection unit 33. In an exemplary embodiment of the present disclosure, the low-voltage ride-through detection device may be provided in a converter controller of a wind turbine.

The adjustment value determination unit 31 is configured to determine an adjustment value of a preset parameter of a power grid on the basis of a power grid voltage.

In an exemplary embodiment of the present disclosure, the preset parameter may include a current, a current frequency and a power factor angle.

In an exemplary embodiment of the present disclosure, the adjustment value determination unit 31 may be configured to acquire a Q-axis component of the power grid voltage; and calculate an active current limiting amplitude output by a wind turbine on the basis of the Q-axis component of the power grid voltage.

In an exemplary embodiment of the present disclosure, the adjustment value determination unit 31 may be configured to calculate the Q-axis component of the power grid voltage by a converter phase-locked loop.

In an exemplary embodiment of the present disclosure, the adjustment value determination unit 31 may be configured to perform a filtering process on the Q-axis component of the power grid voltage; calculate the active current limiting amplitude output by the wind turbine according to the processed Q-axis component.

In an exemplary embodiment of the present disclosure, the adjustment value determination unit 31 may be configured to calculate the Q-axis component of the power grid voltage by the converter phase-locked loop, perform a filtering process on the Q-axis component of the power grid voltage, calculate the active current limiting amplitude output by the wind turbine according to the processed Q-axis component.

In an exemplary embodiment of the present disclosure, the adjustment value determination unit 31 may be configured to perform a low-pass filtering process on the active current limiting amplitude by variable rate filtering.

In an exemplary embodiment of the present disclosure, the adjustment value determination unit 31 may be configured to calculate an apparent current output by the wind turbine on the basis of the processed Q-axis component and a rated grid-connected apparent current of a wind turbine; and calculate the active current limiting amplitude output by the wind turbine on the basis of the apparent current output by the wind turbine.

The parameter adjustment unit 32 is configured to adjust the preset parameter of the power grid on the basis of the adjustment value.

The low-voltage ride-through detection unit 33 is configured to detect, on the basis of a power grid voltage after the preset parameter of the power grid is adjusted, whether the power grid meets a low-voltage ride-through condition.

In an exemplary embodiment of the present disclosure, the low-voltage ride-through detection unit 33 may be configured to acquire a D-axis component and a Q-axis component of the power grid voltage after the preset parameter of the power grid is adjusted; calculate a vector sum of the D-axis component and the Q-axis component of the power grid voltage after the preset parameter is adjusted to obtain a positive sequence voltage amplitude of the power grid voltage after the preset parameter is adjusted; perform a low-pass filtering process on the positive sequence voltage amplitude; and detect, on the basis of a processed positive sequence voltage amplitude and a preset low-voltage ride-through threshold, whether the power grid meets a low-voltage ride-through condition.

In an exemplary embodiment of the present disclosure, the low-voltage ride-through detection unit 33 may be configured to calculate a difference between the preset low-voltage ride-through threshold and the processed positive sequence voltage amplitude; input the difference to a hysteresis controller; under a condition that the difference is greater than an entering hysteresis value of the hysteresis controller, start to count by a delay counter, and determine that the power grid meets the low-voltage ride-through condition under a condition that the count value of the delay counter reaches a target delay; and under a condition that the difference is less than an exit hysteresis value of the hysteresis controller, start to count by the delay counter, and determine that the power grid does not meet the low-voltage ride-through condition under a condition that the count value of the delay counter reaches the target delay.

In addition, according to an exemplary embodiment of the present disclosure, there is also provided a converter including the low-voltage ride-through detection device shown in Fig. 3. In addition, according to an exemplary embodiment of the present disclosure, there is also provided a wind turbine including the above converter including the low-voltage ride-through detection device shown in Fig. 3.

The low-voltage ride-through detection device according to an exemplary embodiment of the present disclosure has been described above in connection with Fig. 3. Next, a computing device according to an exemplary embodiment of the present disclosure is described in connection with Fig. 4.

Fig. 4 shows a schematic diagram of the computing device according to an exemplary embodiment of the present disclosure.

Referring to Fig. 4, a computing device 4 according to an exemplary embodiment of the present disclosure includes a memory 41 and a processor 42, the memory 41 has stored thereon computer programs that, when executed by the processor 42, implement the low-voltage ride-through detection method according to an exemplary embodiment of the present disclosure.

In an exemplary embodiment of the present disclosure, the computer programs, when executed by processor 42, can implement the following steps: determining an adjustment value of a preset parameter of a power grid on the basis of a power grid voltage, wherein the preset parameter includes at least one of a current, a current frequency and a power factor angle; adjusting the preset parameter of the power grid on the basis of the adjustment value; and detecting, on the basis of a power grid voltage after the preset parameter of the power grid is adjusted, whether the power grid meets a low-voltage ride-through condition.

The computing device shown in Fig. 4 is only one example and should not impose any limitations on the functionality and scope of use of the embodiments of the present disclosure.

The low-voltage ride-through detection method and device according to an exemplary embodiment of the present disclosure has been described above with reference to Figs. 1-4. However, it should be understood that the low-voltage ride-through detection device and its units shown in Fig. 3 may each be configured as software, hardware, firmware or any combination of the above to perform a particular functionality, the computing device shown in Fig. 4 is not limited to include the components shown above, but some components may be added or deleted as needed, and the above components may also be combined.

For the low-voltage ride-through detection method and device according to the exemplary embodiments of the present disclosure, by firstly determining an adjustment value of a preset parameter of a power grid on the basis of a power grid voltage, wherein the preset parameter includes at least one of a current, a current frequency and a power factor angle, adjusting the preset parameter of the power grid on the basis of the adjustment value, and then detecting, on the basis of a power grid voltage after the preset parameter is adjusted, whether the power grid meets a low-voltage ride-through condition, a power grid fault can be accurately identified by the wind turbine in a weak grid, so as to enter a low-voltage ride-through state, thereby avoiding system instability in the process of a power grid fault ride-through in the weak grid. The low-voltage ride-through detection method and device according to an exemplary embodiment of the present disclosure greatly facilitate the development of an ultra-high voltage transmission in conjunction with a large base wind farm.

## Claims

1. A low-voltage ride-through detection method for a wind turbine, **characterized by** comprising:
determining, by a converter of the wind turbine, an adjustment value of a preset parameter of a power grid on the basis of a power grid voltage measured by the converter (S101), wherein the preset parameter comprises at least one of a current, a current frequency and a power factor angle;
adjusting, by the converter, the preset parameter of the power grid on the basis of the adjustment value (S102); and
detecting by the converter, on the basis of a power grid voltage after the preset parameter of the power grid is adjusted, whether the power grid meets a low-voltage ride-through condition (S103).

2. The low-voltage ride-through detection method according to claim 1, wherein the step of determining an adjustment value of a preset parameter of a power grid on the basis of a power grid voltage measured by the converter (S101) comprises:
calculating a Q-axis component of the power grid voltage by a converter phase-locked loop;
performing a filtering process on the Q-axis component of the power grid voltage; and
calculating an active current limiting amplitude output by the wind turbine according to the processed Q-axis component.

3. The low-voltage ride-through detection method according to claim 2, wherein the step of calculating an active current limiting amplitude output by the wind turbine according to the processed Q-axis component comprises:
calculating an apparent current output by the wind turbine on the basis of the processed Q-axis component and a rated grid-connected apparent current of the wind turbine; and
calculating the active current limiting amplitude output by the wind turbine on the basis of the apparent current output by the wind turbine.

4. The low-voltage ride-through detection method according to any of claims 1-3, wherein the step of detecting, on the basis of a power grid voltage after the preset parameter of the power grid is adjusted, whether the power grid meets a low-voltage ride-through condition (S103) comprises:
acquiring a D-axis component and a Q-axis component of the power grid voltage after the preset parameter of the power grid is adjusted;
calculating a vector sum of the D-axis component and the Q-axis component of the power grid voltage to obtain a positive sequence voltage amplitude of the power grid voltage;
performing a low-pass filtering process on the positive sequence voltage amplitude; and
detecting, on the basis of the processed positive sequence voltage amplitude and a preset low-voltage ride-through threshold, whether the power grid meets the low-voltage ride-through condition.

5. The low-voltage ride-through detection method according to claim 4, wherein the step of detecting, on the basis of the processed positive sequence voltage amplitude and a preset low-voltage ride-through threshold, whether the power grid meets the low-voltage ride-through condition comprises:
calculating a difference between the preset low-voltage ride-through threshold and the processed positive sequence voltage amplitude;
inputting the difference to a hysteresis controller;
under a condition that the difference is greater than an entering hysteresis value of the hysteresis controller, starting to count by a delay counter, and determining that the power grid meets the low-voltage ride-through condition under a condition that a count value of the delay counter reaches a target delay; and
under a condition that the difference is less than an exit hysteresis value of the hysteresis controller, starting to count by the delay counter, and determining that the power grid does not meet the low-voltage ride-through condition under a condition that the count value of the delay counter reaches the target delay.

6. A low-voltage ride-through detection device, **characterized by** comprising:
an adjustment value determination unit (31) configured to determine an adjustment value of a preset parameter of a power grid on the basis of a power grid voltage measured by a converter of a wind turbine, wherein the preset parameter comprises at least one of a current, a current frequency and a power factor angle;
a parameter adjustment unit (32) configured to adjust the preset parameter of the power grid on the basis of the adjustment value; and
a low-voltage ride-through detection unit (33) configured to detect, on the basis of a power grid voltage after the preset parameter of the power grid is adjusted, whether the power grid meets a low-voltage ride-through condition.

7. The low-voltage ride-through detection device according to claim 6, wherein the adjustment value determination unit (31) is configured to:
calculate a Q-axis component of the power grid voltage by a converter phase-locked loop;
perform a filtering process on the Q-axis component of the power grid voltage;
calculate an active current limiting amplitude output by the wind turbine according to the processed Q-axis component.

8. The low-voltage ride-through detection device according to claim 6 or 7, wherein the low-voltage ride-through detection unit (33) is configured to:
acquire a D-axis component and a Q-axis component of the power grid voltage after the preset parameter of the power grid is adjusted;
calculate a vector sum of the D-axis component and the Q-axis component of the power grid voltage to obtain a positive sequence voltage amplitude of the power grid voltage;
perform a low-pass filtering process on the positive sequence voltage amplitude; and
detect, on the basis of the processed positive sequence voltage amplitude and a preset low-voltage ride-through threshold, whether the power grid meets the low-voltage ride-through condition.

9. The low-voltage ride-through detection device according to claim 8, wherein the low-voltage ride-through detection unit (33) is configured to:
calculate a difference between the preset low-voltage ride-through threshold and the processed positive sequence voltage amplitude;
input the difference to a hysteresis controller;
under a condition that the difference is greater than an entering hysteresis value of the hysteresis controller, start to count by a delay counter, and determine that the power grid meets the low-voltage ride-through condition under a condition that a count value of the delay counter reaches a target delay;
under a condition that the difference is less than an exit hysteresis value of the hysteresis controller, start to count by the delay counter, and determine that the power grid does not meet the low-voltage ride-through condition under a condition that the count value of the delay counter reaches the target delay.

10. The device according to claim 8, wherein the device is provided in a converter controller of the wind turbine.

11. A converter, **characterized by** comprising the low-voltage ride-through detection device according to any of claims 6-10.

12. A wind turbine, **characterized by** comprising the converter according to claim 11.

13. A computer-readable storage medium having stored thereon computer programs that, when executed by a processor, implement the low-voltage ride-through detection method according to any of claims 1-5.

14. A computing device (4), **characterized by** comprising: at least one processor (42); at least one memory (41) storing computer programs that, when executed by the at least one processor (42), implement the low-voltage ride-through detection method according to any of claims 1-5.

15. A computer program product, wherein instructions in the computer program product are executable by a processor (42) of a computer device (4) to implement the low-voltage ride-through detection method according to any of claims 1-5.

## Patentansprüche

1. Verfahren zur Erkennung einer Niederspannungs-Durchfahrt für eine Windturbine, **dadurch gekennzeichnet, dass** es Folgendes umfasst:
Bestimmen, durch einen Wandler der Windturbine, eines Anpassungswerts eines voreingestellten Parameters eines Stromnetzes auf Grundlage einer Stromnetzspannung, die durch den Wandler (S101) gemessen wird, wobei der voreingestellte Parameter mindestens eines von einem Strom, einer Stromfrequenz und einem Leistungsfaktorwinkel umfasst;
Anpassen, durch den Wandler, des voreingestellten Parameters des Stromnetzes auf Grundlage des Anpassungswerts (S102); und
Erkennen, durch den Wandler auf Grundlage einer Stromnetzspannung, nachdem der voreingestellte Parameter des Stromnetzes angepasst wurde, ob das Stromnetz eine Bedingung einer Niederspannungs-Durchfahrt erfüllt (S103).

2. Verfahren zur Erkennung einer Niederspannungs-Durchfahrt nach Anspruch 1, wobei der Schritt des Bestimmens eines Anpassungswerts eines voreingestellten Parameters eines Stromnetzes auf Grundlage einer Stromnetzspannung, die durch den Wandler (S101) gemessen wird, Folgendes umfasst:
Berechnen einer Q-Achsen-Komponente der Stromnetzspannung durch einen Phasenregelkreis des Wandlers;
Durchführen eines Filterprozesses an der Q-Achsen-Komponente der Stromnetzspannung; und
Berechnen einer durch die Windturbine ausgegebenen aktiven Strombegrenzungsamplitude gemäß der verarbeiteten Q-Achsen-Komponente.

3. Verfahren zur Erkennung einer Niederspannungs-Durchfahrt nach Anspruch 2, wobei der Schritt des Berechnens einer durch die Windturbine ausgegebenen aktiven Strombegrenzungsamplitude gemäß der verarbeiteten Q-Achsen-Komponente Folgendes umfasst:
Berechnen eines durch die Windturbine ausgegebenen Scheinstroms auf Grundlage der verarbeiteten Q-Achsen-Komponente und eines netzgekoppelten Nennscheinstroms der Windturbine; und
Berechnen der durch die Windturbine ausgegebenen aktiven Strombegrenzungsamplitude auf der Grundlage des durch die Windturbine ausgegebenen Scheinstroms.

4. Verfahren zur Erkennung einer Niederspannungs-Durchfahrt nach einem der Ansprüche 1-3, wobei der Schritt des Erkennens, auf Grundlage einer Stromnetzspannung, nachdem der voreingestellte Parameter des Stromnetzes angepasst wurde, ob das Stromnetz eine Bedingung einer Niederspannungs-Durchfahrt erfüllt (S103), Folgendes umfasst:
Erfassen einer D-Achsen-Komponente und einer Q-Achsen-Komponente der Stromnetzspannung, nachdem der voreingestellte Parameter des Stromnetzes angepasst wurde;
Berechnen einer Vektorsumme der D-Achsen-Komponente und der Q-Achsen-Komponente der Stromnetzspannung, um eine Spannungsamplitude des Mitsystems der Stromnetzspannung zu erhalten;
Durchführen eines Tiefpassfilterprozesses an der Spannungsamplitude des Mitsystems; und
Erkennen, auf Grundlage der verarbeiteten Spannungsamplitude des Mitsystems und eines voreingestellten Schwellenwerts für eine Niederspannungs-Durchfahrt, ob das Stromnetz die Bedingung einer Niederspannungs-Durchfahrt erfüllt.

5. Verfahren zur Erkennung einer Niederspannungs-Durchfahrt nach Anspruch 4, wobei der Schritt des Erkennens, auf Grundlage der verarbeiteten Spannungsamplitude des Mitsystems und eines voreingestellten Schwellenwerts für eine Niederspannungs-Durchfahrt, ob das Stromnetz die Bedingung einer Niederspannungs-Durchfahrt erfüllt, Folgendes umfasst:
Berechnen einer Differenz zwischen dem voreingestellten Schwellenwert für eine Niederspannungs-Durchfahrt und der verarbeiteten Spannungsamplitude des Mitsystems;
Eingeben der Differenz in eine Hysteresesteuerung;
unter einer Bedingung, dass die Differenz größer als ein Eintrittshysteresewert der Hysteresesteuerung ist, Beginnen eines Zählens durch einen Verzögerungszähler und Bestimmen, dass das Stromnetz die Bedingung einer Niederspannungs-Durchfahrt erfüllt, unter einer Bedingung, dass ein Zählwert des Verzögerungszählers eine Sollverzögerung erreicht; und
unter einer Bedingung, dass die Differenz kleiner als ein Austrittshysteresewert der Hysteresesteuerung ist, Beginnen eines Zählens durch den Verzögerungszähler und Bestimmen, dass das Stromnetz die Bedingung einer Niederspannungs-Durchfahrt nicht erfüllt, unter einer Bedingung, dass der Zählwert des Verzögerungszählers die Sollverzögerung erreicht.

6. Vorrichtung zur Erkennung einer Niederspannungs-Durchfahrt, **dadurch gekennzeichnet, dass** sie Folgendes umfasst:
eine Anpassungswertbestimmungseinheit (31), die dazu ausgelegt ist, einen Anpassungswert eines voreingestellten Parameters eines Stromnetzes auf Grundlage einer Stromnetzspannung zu bestimmen, die durch einen Wandler einer Windturbine gemessen wird, wobei der voreingestellte Parameter mindestens eines von einem Strom, einer Stromfrequenz und einem Leistungsfaktorwinkel umfasst;
eine Parameteranpassungseinheit (32), die dazu ausgelegt ist, den voreingestellten Parameter des Stromnetzes auf Grundlage des Anpassungswerts anzupassen; und
eine Niederspannungs-Durchfahrt-Erkennungseinheit (33), die dazu ausgelegt ist, auf Grundlage einer Stromnetzspannung, nachdem der voreingestellte Parameter des Stromnetzes angepasst wurde, zu erkennen, ob das Stromnetz eine Bedingung einer Niederspannungs-Durchfahrt erfüllt.

7. Vorrichtung zur Erkennung einer Niederspannungs-Durchfahrt nach Anspruch 6, wobei die Anpassungswertbestimmungseinheit (31) zu Folgendem ausgelegt ist:
Berechnen einer Q-Achsen-Komponente der Stromnetzspannung durch einen Phasenregelkreis des Wandlers;
Durchführen eines Filterprozesses an der Q-Achsen-Komponente der Stromnetzspannung;
Berechnen einer durch die Windturbine ausgegebenen aktiven Strombegrenzungsamplitude gemäß der verarbeiteten Q-Achsen-Komponente.

8. Vorrichtung zur Erkennung einer Niederspannungs-Durchfahrt nach Anspruch 6 oder 7, wobei die Niederspannungs-Durchfahrt-Erkennungseinheit (33) zu Folgendem ausgelegt ist:
Erfassen einer D-Achsen-Komponente und einer Q-Achsen-Komponente der Stromnetzspannung, nachdem der voreingestellte Parameter des Stromnetzes angepasst wurde;
Berechnen einer Vektorsumme der D-Achsen-Komponente und der Q-Achsen-Komponente der Stromnetzspannung, um eine Spannungsamplitude des Mitsystems der Stromnetzspannung zu erhalten;
Durchführen eines Tiefpassfilterprozesses an der Spannungsamplitude des Mitsystems; und
Erkennen, auf Grundlage der verarbeiteten Spannungsamplitude des Mitsystems und eines voreingestellten Schwellenwerts für eine Niederspannungs-Durchfahrt, ob das Stromnetz die Bedingung einer Niederspannungs-Durchfahrt erfüllt.

9. Vorrichtung zur Erkennung einer Niederspannungs-Durchfahrt nach Anspruch 8, wobei die Niederspannungs-Durchfahrt-Erkennungseinheit (33) zu Folgendem ausgelegt ist:
Berechnen einer Differenz zwischen dem voreingestellten Schwellenwert für eine Niederspannungs-Durchfahrt und der verarbeiteten Spannungsamplitude des Mitsystems;
Eingeben der Differenz in eine Hysteresesteuerung;
unter einer Bedingung, dass die Differenz größer als ein Eintrittshysteresewert der Hysteresesteuerung ist, Beginnen eines Zählens durch einen Verzögerungszähler und Bestimmen, dass das Stromnetz die Bedingung einer Niederspannungs-Durchfahrt erfüllt, unter einer Bedingung, dass ein Zählwert des Verzögerungszählers eine Sollverzögerung erreicht;
unter einer Bedingung, dass die Differenz kleiner als ein Austrittshysteresewert der Hysteresesteuerung ist, Beginnen eines Zählens durch den Verzögerungszähler und Bestimmen, dass das Stromnetz die Bedingung einer Niederspannungs-Durchfahrt nicht erfüllt, unter einer Bedingung, dass der Zählwert des Verzögerungszählers die Sollverzögerung erreicht.

10. Vorrichtung nach Anspruch 8, wobei die Vorrichtung in einer Wandlersteuerung der Windturbine bereitgestellt ist.

11. Wandler, **dadurch gekennzeichnet, dass** er die Vorrichtung zur Erkennung einer Niederspannungs-Durchfahrt nach einem der Ansprüche 6-10 umfasst.

12. Windturbine, **dadurch gekennzeichnet, dass** sie den Wandler nach Anspruch 11 umfasst.

13. Computerlesbares Speichermedium, auf dem Computerprogramme gespeichert sind, die bei Ausführung durch einen Prozessor das Verfahren zur Erkennung einer Niederspannungs-Durchfahrt nach einem der Ansprüche 1-5 umsetzen.

14. Rechenvorrichtung (4), **dadurch gekennzeichnet, dass** sie Folgendes umfasst: mindestens einen Prozessor (42); mindestens einen Speicher (41), auf dem Computerprogramme gespeichert sind, die bei Ausführung durch den mindestens einen Prozessor (42) das Verfahren zur Erkennung einer Niederspannungs-Durchfahrt nach einem der Ansprüche 1-5 umsetzen.

15. Computerprogrammprodukt, wobei Anweisungen in dem Computerprogrammprodukt durch einen Prozessor (42) einer Computervorrichtung (4) ausführbar sind, um das Verfahren zur Erkennung einer Niederspannungs-Durchfahrt nach einem der Ansprüche 1-5 umzusetzen.

## Revendications

1. Procédé de détection de tenue aux creux de tension pour une éolienne, **caractérisé en ce qu'**il comprend :
la détermination, par un convertisseur de l'éolienne, d'une valeur d'ajustement d'un paramètre prédéterminé d'un réseau électrique à partir d'une tension de réseau électrique mesurée par le convertisseur (S101), le paramètre prédéterminé comprenant au moins l'un(e) parmi un courant, une fréquence de courant et un angle de facteur de puissance ;
l'ajustement, par le convertisseur, du paramètre prédéterminé du réseau électrique à partir de la valeur d'ajustement (S102) ; et
la détection, par le convertisseur, à partir d'une tension de réseau électrique après l'ajustement du paramètre prédéterminé du réseau électrique, de la satisfaction par le réseau électrique d'une condition de tenue aux creux de tension (S103).

2. Procédé de détection de tenue aux creux de tension selon la revendication 1, dans lequel l'étape de détermination d'une valeur d'ajustement d'un paramètre prédéterminé d'un réseau électrique à partir d'une tension de réseau électrique mesurée par le convertisseur (S101) comprend :
le calcul d'une composante d'axe Q de la tension de réseau électrique par une boucle à verrouillage de phase du convertisseur ;
l'exécution d'un filtrage sur la composante d'axe Q de la tension de réseau électrique ; et
le calcul d'une amplitude de limitation de courant actif délivrée par l'éolienne selon la composante d'axe Q traitée.

3. Procédé de détection de tenue aux creux de tension selon la revendication 2, dans lequel l'étape de calcul d'une amplitude de limitation de courant actif délivrée par l'éolienne selon la composante d'axe Q traitée comprend :
le calcul d'un courant apparent délivré par l'éolienne à partir de la composante d'axe Q traitée et d'un courant apparent nominal raccordé au réseau de l'éolienne ; et
le calcul de l'amplitude de limitation de courant actif délivrée par l'éolienne à partir du courant apparent délivré par l'éolienne.

4. Procédé de détection de tenue aux creux de tension selon l'une des revendications 1 à 3, dans lequel l'étape de détection, à partir d'une tension de réseau électrique après l'ajustement du paramètre prédéterminé du réseau électrique, de la satisfaction par le réseau électrique d'une condition de tenue aux creux de tension (S103) comprend :
l'acquisition d'une composante d'axe D et d'une composante d'axe Q de la tension de réseau électrique après l'ajustement du paramètre prédéterminé du réseau électrique ;
le calcul d'une somme vectorielle de la composante d'axe D et de la composante d'axe Q de la tension de réseau électrique pour obtenir une amplitude de tension de séquence positive de la tension de réseau électrique ;
l'exécution d'un filtrage passe-bas sur l'amplitude de tension de séquence positive ; et
la détection, à partir de l'amplitude de tension de séquence positive traitée et d'un seuil de tenue aux creux de tension prédéterminé, de la satisfaction par le réseau électrique de la condition de tenue aux creux de tension.

5. Procédé de détection de tenue aux creux de tension selon la revendication 4, dans lequel l'étape de détection, à partir de l'amplitude de tension de séquence positive traitée et d'un seuil de tenue aux creux de tension prédéterminé, de la satisfaction par le réseau électrique de la condition de tenue aux creux de tension comprend :
le calcul d'une différence entre le seuil de tenue aux creux de tension prédéterminé et l'amplitude de tension de séquence positive traitée ;
la saisie de la différence sur un dispositif de commande d'hystérésis ;
à condition que la différence soit supérieure à une valeur d'hystérésis d'entrée du dispositif de commande d'hystérésis, le démarrage d'un décompte par un compteur de retard, et la détermination de la satisfaction par le réseau électrique de la condition de tenue aux creux de tension à condition qu'une valeur de comptage du compteur de retard atteigne un retard cible ; et
à condition que la différence soit inférieure à une valeur d'hystérésis de sortie du dispositif de commande d'hystérésis, le démarrage d'un décompte par le compteur de retard, et la détermination de la non-satisfaction par le réseau électrique de la condition de tenue aux creux de tension à condition que la valeur de comptage du compteur de retard atteigne le retard cible.

6. Dispositif de détection de tenue aux creux de tension, **caractérisé en ce qu'**il comprend :
une unité de détermination de valeur d'ajustement (31) configurée de manière à déterminer une valeur d'ajustement d'un paramètre prédéterminé d'un réseau électrique à partir d'une tension de réseau électrique mesurée par un convertisseur d'une éolienne, le paramètre prédéterminé comprenant au moins l'un(e) parmi un courant, une fréquence de courant et un angle de facteur de puissance ;
une unité d'ajustement de paramètre (32) configurée de manière à ajuster le paramètre prédéterminé du réseau électrique à partir de la valeur d'ajustement ; et
une unité de détection de tenue aux creux de tension (33) configurée de manière à détecter, à partir d'une tension de réseau électrique après l'ajustement du paramètre prédéterminé du réseau électrique, si le réseau électrique satisfait une condition de tenue aux creux de tension.

7. Dispositif de détection de tenue aux creux de tension selon la revendication 6, dans lequel l'unité de détermination de valeur d'ajustement (31) est configurée de manière à :
calculer une composante d'axe Q de la tension de réseau électrique par une boucle à verrouillage de phase du convertisseur ;
exécuter un filtrage sur la composante d'axe Q de la tension de réseau électrique ;
calculer une amplitude de limitation de courant actif délivrée par l'éolienne selon la composante d'axe Q traitée.

8. Dispositif de détection de tenue aux creux de tension selon la revendication 6 ou 7, dans lequel l'unité de détection de tenue aux creux de tension (33) est configurée de manière à :
acquérir une composante d'axe D et une composante d'axe Q de la tension de réseau électrique après l'ajustement du paramètre prédéterminé du réseau électrique ;
calculer une somme vectorielle de la composante d'axe D et de la composante d'axe Q de la tension de réseau électrique pour obtenir une amplitude de tension de séquence positive de la tension de réseau électrique ;
exécuter un filtrage passe-bas sur l'amplitude de tension de séquence positive ; et
détecter, à partir de l'amplitude de tension de séquence positive traitée et d'un seuil de tenue aux creux de tension prédéterminé, si le réseau électrique satisfait la condition de tenue aux creux de tension.

9. Dispositif de détection de tenue aux creux de tension selon la revendication 8, dans lequel l'unité de détection de tenue aux creux de tension (33) est configurée de manière à :
calculer une différence entre le seuil de tenue aux creux de tension prédéterminé et l'amplitude de tension de séquence positive traitée ;
saisir la différence sur un dispositif de commande d'hystérésis ;
à condition que la différence soit supérieure à une valeur d'hystérésis d'entrée du dispositif de commande d'hystérésis, démarrer un décompte par un compteur de retard, et déterminer que le réseau électrique satisfait la condition de tenue aux creux de tension à condition qu'une valeur de comptage du compteur de retard atteigne un retard cible ;
à condition que la différence soit inférieure à une valeur d'hystérésis de sortie du dispositif de commande d'hystérésis, démarrer un décompte par le compteur de retard, et déterminer que le réseau électrique ne satisfait pas la condition de tenue aux creux de tension à condition que la valeur de comptage du compteur de retard atteigne le retard cible.

10. Dispositif selon la revendication 8, dans lequel le dispositif est prévu dans un dispositif de commande de convertisseur de l'éolienne.

11. Convertisseur, **caractérisé en ce qu'**il comprend le dispositif de détection de tenue aux creux de tension selon l'une des revendications 6 à 10.

12. Éolienne, **caractérisée en ce qu'**elle comprend le convertisseur selon la revendication 11.

13. Support de stockage lisible par ordinateur sur lequel sont stockés des programmes informatiques qui, lorsqu'ils sont exécutés par un processeur, mettent en œuvre le procédé de détection de tenue aux creux de tension selon l'une des revendications 1 à 5.

14. Dispositif de calcul (4), **caractérisé en ce qu'**il comprend : au moins un processeur (42) ; au moins une mémoire (41) stockant des programmes informatiques qui, lorsqu'ils sont exécutés par ledit au moins un processeur (42), mettent en œuvre le procédé de détection de tenue aux creux de tension selon l'une des revendications 1 à 5.

15. Produit programme informatique, dans lequel les instructions dans le produit programme informatique sont exécutables par un processeur (42) d'un dispositif informatique (4) pour mettre en œuvre le procédé de détection de tenue aux creux de tension selon l'une des revendications 1 à 5.
